# EUROPÄISCHE PATENTSCHRIFT

(11) **EP 2 472 689 B1**
(45) Veröffentlichungstag und Bekanntmachung des Hinweises auf die Patenterteilung: **11.03.2020**
(21) Anmeldenummer: 11192360.3
(22) Anmeldetag: 07.12.2011
(51) Int. Cl.: H02G 15/103, G01D 5/26, G01R 31/12, G01D 5/353, G01R 31/14

(54) **Hochspannungsgarnitur und Verfahren zur Detektion von Teilentladungen in Hochspannungsgarnituren**
High voltage fitting and method for detecting partial discharges in high voltage fittings
Garniture haute tension et procédé de détection de décharges partielles dans les garnitures haute tension

(30) Priorität: 28.12.2010 DE 102010061606
(43) Veröffentlichungstag der Anmeldung: 04.07.2012
(73) Patentinhaber: BAM Bundesanstalt für Materialforschung und -prüfung, 12205 Berlin (DE); IPH Institut "Prüffeld für elektrische Hochleistungstechnik" GmbH, 12681 Berlin (DE)
(72) Erfinder: Habel, Wolfgang, 13125 Berlin (DE); Heidmann, Gerd, 10319 Berlin (DE)
(74) Vertreter: Zimmermann & Partner Patentanwälte mbB

(56) Entgegenhaltungen:
- WO-A1-97/09762
- DE-A1- 1 490 580
- DE-A1- 3 822 288
- DE-A1- 19 514 852
- DE-A1-102009 007 142
- FR-A1- 2 397 732
- GB-A- 2 429 790
- JP-A- H02 269 980
- JP-A- H03 128 471
- US-A1- 2005 134 837
- BANJI ET AL: "Electroluminescence - a technique to detect the initiation of degradation in polymeric insulation", 19990601; 19990600, vol. 15, no. 3, 1 June 1999 (1999-06-01), pages 9-14, XP011084569,

## Beschreibung

Die vorliegende Erfindung betrifft ein Verfahren zur Detektion von Teilentladungen (TE) und/oder von Strukturschädigungen in einer Isolierung in Hochspannungsgarnituren sowie eine zugehörige Hochspannungsgarnitur, gemäß Anspruch 1.

In elektrischen Anlagen zur Energieversorgung kommt es auf Grund von schädigenden Einflüssen auf die Hochspannungsgarnitur und Alterungserscheinungen der Isolierungen immer wieder zu Ausfällen. Hauptsächlich werden diese Ausfälle durch Teilentladungen verursacht. Während der Teilentladungen entstehen sogenannte Teilentladungsbäumchen, die im Laufe der Zeit wachsen und schließlich zu einem elektrischen Durchschlag führen, falls die betroffenen Anlagen nicht rechtzeitig abgeschaltet werden. Teilentladungen in Isolierungen von Kabelgarnituren, wie Endverschlüsse und Kabelmuffen für Starkstromkabel bzw. Hochspannungskabel, können in fortgeschrittenem Stadium daher zur Totalzerstörung der Kabelgarnituren führen. Auf Grund der mit dem Durchschlag verbundenen hohen Energiefreisetzung können dabei weitere Teile der Anlagen beschädigt werden. Die Schäden dieser zwar eher seltenen Ereignisse können daher beträchtlich sein. Daher besteht ein Bedarf, Alterungserscheinungen bzw. Teilentladungen in Isolierungen von Hochspannungsgarnituren möglichst im laufenden Betrieb zuverlässig zu detektieren und zu bewerten.

Eine bisher etablierte Methode besteht in der Messung elektrischer Stromimpulse und/oder elektromagnetischer Signale, die mit dem Auftreten von Teilentladungen verbunden sind. Die Interpretation dieser Messergebnisse ist unter Praxisbedingungen wegen elektromagnetischer Störungen jedoch häufig schwierig. Außerdem sind diese Messungen sehr aufwendig und erfordern typischerweise den Aufbau geeigneter Mess- und Prüfanlagen vor Ort. Daher erfolgt die Überwachung typischerweise nur in größeren Zeitabständen oder bei Vermutung entstehender Schädigungen. Zudem wird die Messempfindlichkeit von elektromagnetischen Umweltstörungen begrenzt, so dass Teilentladungen erst in einem späten Stadium, d.h. kurz vor dem Durchbruch, erfasst werden. Elektromagnetische Messungen können nämlich nur in sicheren Zugangsbereichen, d.h. außerhalb des Hochspannungsbereichs, durchgeführt werden.

Auf Grund des höheren Abstands zum Ort der Teilentladung können daher nur Teilentladungen ab einer bestimmten Intensität detektiert werden. Stand der Technik ist in DE 14 90 580 A1, DE 10 2009 007142 A1 und US 2005/134837 A1 zu finden.

Im Hinblick auf das oben Gesagte, schlägt die vorliegende Erfindung eine Hochspannungsgarnitur gemäß Anspruch 1 und ein Verfahren gemäß Anspruch 7 vor.

Gemäß einem Ausführungsbeispiel ist die Hochspannungsgarnitur so ausgeführt, dass sie ein Hochspannungskabel mit einem zum Leiten elektrischen Stroms eingerichteten Leiter und einer den Leiter umgebenden Kabelisolierung aufnehmen kann. Die Hochspannungsgarnitur umfasst eine Isolierung, die ein Feldsteuerteil umfasst, das eingerichtet ist, die Kabelisolierung zumindest teilweise zu umgeben. Typischerweise ist das Feldsteuerteil ein elastomerer Feldsteuerkörper mit integriertem Deflektor zur Veränderung des elektrischen Feldverlaufs in der Hochspannungsgarnitur. Das Feldsteuerteil nimmt dazu typischerweise denjenigen Raum in der Hochspannungsgarnitur ein, in dem die Feldstärke im Hochspannungsbetrieb zu groß für die übrige Isolierung ist. Das Feldsteuerteil kann insbesondere als Feldsteuerkonus mit einem integrierten leitfähigen Deflektor ausgebildet sein. Damit kann das Feldsteuerteil die Feldlinien im Hochspannungsbetrieb der Hochspannungsgarnitur so führen, dass die Feldstärke außerhalb des Feldsteuerteils hinreichend niedrig ist. Außerdem umfasst die Hochspannungsgarnitur mindestens einen mit dem Feldsteuerteil mechanisch gekoppelten faseroptischen Sensor, der typischerweise im Innern der Hochspannungsgarnitur angeordnet ist. Der mindestens eine faseroptische Sensor ist so eingerichtet, dass er eine mechanische Deformation der Isolierung detektieren kann. Damit kann eine in der Isolierung der Hochspannungsgarnitur oder in der Kabelisolierung auftretende elektrische Teilentladung über eine damit verbundene Deformation der Isolierung nachgewiesen werden.

Der Begriff "Hochspannung", wie er vorliegend verwendet wird, soll Spannungen oberhalb von etwa 1 kV umfassen, insbesondere soll der Begriff Hochspannung die in der Energieübertragung üblichen Nennspannungsbereiche der Mittelspannung von etwa 3 kV bis etwa 50 kV, der Hochspannung von etwa 50 kV bis etwa 110 kV als auch Höchstspannungen bis derzeit etwa 500 kV umfassen. Für den Fall, dass die Kabelbetriebsspannungen weiter erhöht werden, sollen auch diese Spannungsbereiche mit umfasst werden. Dabei kann es sich sowohl um Gleichspannungen als auch um Wechselspannungen handeln. Der Begriff "Hochspannungskabel", wie er vorliegend verwendet wird, soll ein Kabel beschreiben, das dazu geeignet ist, Starkstrom, d.h. elektrischen Strom von mehr als etwa einem Ampère bei Spannungen oberhalb von etwa 1 kV, zu führen. Im Folgenden werden die Begriffe Hochspannungskabel und Starkstromkabel synonym verwendet. Dementsprechend soll der Begriff der "Hochspannungsgarnitur" oder "Hochspannungskabelgarnitur" eine Vorrichtung beschreiben, die geeignet ist, Hochspannungsanlagen und/oder Hochspannungskabel miteinander zu verbinden.

Der Begriff "Teilentladung", wie er vorliegend verwendet wird, soll kurzzeitige, energiearme und lokal begrenzte Entladungen in der Isolierung, die nicht sofort zu einem elektrischen Durchschlag führen, aber das Material der Isolierung irreversibel schädigen, beschreiben. Der Begriff "Teilentladung" soll insbesondere den Begriff der "inneren Teilentladung", d.h. einer äußerlich nicht unbedingt sichtbaren Entladungserscheinungen in nicht gasförmigen Isoliermaterialien, insbesondere in festen Isoliermaterialien, umfassen. Ausgehend von Fehlstellen, wie Hohlräumen und Fremdeinschlüssen oder Grenzflächen zu anderen Materialien, insbesondere zu hochspannungsführenden Leitern, führen Teilentladungen zu im Laufe der Zeit wachsenden Teilentladungsbäumchen im Isoliermaterial, was schließlich zu einem Durchschlag führen kann. Teilentladungsbäumchen haben typischerweise eine Größe von mehr als etwa 1 µm (Mikrometer). Als Maß für die Stärke einer Teilentladung kann die direkt an den Prüfanschlüssen einer elektrischen Messanordnung messbare scheinbare Ladung verwendet werden. Der Begriff "Teilentladung", wie er vorliegend verwendet wird, soll insbesondere Entladungen in der Isolierung mit scheinbaren Ladungen von mehr als ca. 1 pC umfassen. Je nach Stärke sind Teilentladungen mit kurzen Schallemissionen im Bereich von etwa 10 kHz bis etwa einigen Hundert kHz verbunden. Durch elektrochemische Veränderungen (Reaktionsschwund) und/oder während der Teilentladungen können sich mechanische Spannungen entwickeln und in deren Folge Risse und Spalten im Isoliermaterial bilden.

Typischerweise ist der faseroptische Sensor in direktem Kontakt mit der Isolierung, beispielsweise zumindest teilweise in das Feldsteuerteil eingebettet und befindet sich damit während des Betriebs im elektrischen Hochspannungsfeld. Dadurch können bereits relativ schwache Teilentladungen ohne aufwendige externe Messaufbauten detektiert werden. Faseroptische Sensoren können zum Einen hochempfindlich ausgeführt werden, zum Anderen können sie aus ausschließlich dielektrischen Materialien gefertigt werden, so dass sie prinzipiell im Hochspannungsfeld, d.h. nahe teilentladungsgefährdeter Gebiete oder sogar in teilentladungsgefährdeten Gebieten, eingesetzt werden können, ohne das Hochspannungsfeld signifikant zu verändern. Dies ermöglicht zudem eine einfache kontinuierliche Überwachung des Zustands der Isolierung während des Betriebs der Hochspannungsgarnitur, bspw. durch Übermittlung der Messergebnisse an eine zentrale Auswerteeinheit. So können ein drohender Durchschlag in der Hochspannungsgarnitur frühzeitig erkannt, die Anlage abgeschaltet und durch Austausch der gealterten Isolierung oder der kompletten Hochspannungsgarnitur Folgeschäden vermieden werden.

Insbesondere kann die Hochspannungsgarnitur eine Hochspannungskabelgarnitur, beispielsweise eine Kabelmuffe oder ein Kabelendverschluss, sein. Die Isolierungen in Kabelmuffen und Kabelendverschlüssen sind insbesondere in der Nähe von Leiterenden und/oder in der Nähe von Öffnungen der Kabelisolierung typischerweise hohen elektrischen Feldstärken ausgesetzt. Eine frühe Detektion von Teilentladungen faseroptischer Sensoren bei diesen Vorrichtungen kann daher besonders zur Erhöhung der Betriebssicherheit beitragen.

Gemäß einem Ausführungsbeispiel besteht der Feldsteuerteil aus einem Elastomer, beispielsweise aus einem Silikonelastomer. In dieses lässt sich der faseroptische Sensor einfach integrieren.

Der faseroptische Sensor ist geeignet, eine mechanische Größe der Isolierung zu messen. Bei der zu erfassenden mechanischen Größe kann es sich um eine Ausdehnung, eine Dichteänderung, einen Druck bzw. eine mechanische Spannung, eine Deformation, eine eine mechanische Schwingung charakterisierende Größe und/oder eine Größe handeln, die eine sich ausbreitende und/oder von der Isolierung ausgehende mechanische Welle, d.h. eine Schallwelle, charakterisiert. Die mechanische Größe kann insbesondere eine Schallfrequenz, einen Schalldruck, und/oder eine Schallintensität umfassen. Bei dem faseroptischen Sensor kann es sich um einen Dehnungssensor und/oder einen Biegesensor und/oder einen Schallsensor handeln. Der faseroptische Sensor ist bevorzugt so ausgeführt, dass er mechanische Schwingungen mit Frequenzen im Bereich von etwa 10 kHz bis etwa 5 MHz, insbesondere im Bereich von etwa 10 kHz bis etwa 500 kHz detektieren kann. Diese Frequenzen sind besonders charakteristisch für Teilentladungen. Der faseroptische Sensor kann dabei ein phasensensitiver Sensor, beispielsweise ein interferometrischer Sensor, aber auch ein leistungssensitiver Sensor, d.h. ein intensiometrischer Sensor sein.

Gemäß einer Weiterbildung ist der faseroptische Sensor ein Faserspitzensensor, d.h. ein Sensor bei dem eine Faserspitze bzw. ein Faserende als empfindliches Messelement genutzt wird. Auf Grund der geringen Größe der Faserspitze des Faserspitzensensors kann der faseroptische Sensor in der Isolierung an einen für die Detektion günstigen Ort platziert werden.

Gemäß noch einem Ausführungsbeispiel wird ein Verfahren zur Detektion einer Teilentladung in einer Isolierung einer Hochspannungsgarnitur bereitgestellt. Das Verfahren weist dabei den Schritt der Messung einer mechanischen Größe der Isolierung mittels eines mit der Isolierung mechanisch gekoppelten faseroptischen Sensors auf, der typischerweise im Innern der Hochspannungsgarnitur angeordnet ist. Dies ermöglicht eine einfache Überwachung von Teilentladungsprozessen und damit des Alterungszustands der Hochspannungsgarnitur. Beispielsweise kann die Messung einer mechanischen Größe die Messung eines Drucks, einer Spannung, einer reversiblen oder irreversiblen Deformation und/oder einer Schwingung in der Isolierung umfassen. Zudem erfolgt die Messung der mechanischen Größe typischerweise im stromdurchflossenen Zustand der Hochspannungsgarnitur. Damit kann die Hochspannungsgarnitur im laufenden Betrieb überwacht werden.

Gemäß einer Weiterbildung wird das Verfahren kontinuierlich und/oder ereignisgesteuert ausgeführt, wobei ein oder mehrere Sensoren betrieben werden können. Damit soll sichergestellt werden, dass sämtliche auftretenden Teilentladungen bzw. andere schädigende Einflüsse erfasst werden. Unter dem Begriff einer "zeitlich kontinuierlichen Messung", wie er vorliegend verwendet wird, soll eine Messung verstanden werden, die auch einzelne kurze Signale im Bereich oberhalb einiger Millisekunden in einem Zeitraum von mehreren Stunden, typischerweise mehreren Tagen, oder sogar mehreren Wochen und Monaten detektieren kann. Das Verfahren kann bspw. so ausgeführt werden, dass ein mit dem faseroptischen Sensor verbundener Detektor während eines bis über Monate andauernden Zeitraums durchgängig die vom faseroptischen Sensor gelieferten optischen Signale detektiert, die eigentliche Auswertung der Messung bzw. Bestimmung der damit korrelierten mechanischen Größe in einer Auswerteinheit jedoch nur bei einer Änderung der optischen Signale erfolgt, d.h., wenn sich die mechanische Größe durch ein Ereignis, wie eine elektrische Teilentladung, geändert hat.

Weitere vorteilhafte Ausgestaltungen, Einzelheiten, Aspekte und Merkmale der vorliegenden Erfindung ergeben sich aus den Unteransprüchen, der Beschreibung sowie den beigefügten Zeichnungen. Darin zeigt:
Fig. 1 einen schematischen Querschnitt einer Hochspannungsgarnitur gemäß einem Ausführungsbeispiel;
Fig. 2 einen schematischen Querschnitt einer Hochspannungsgarnitur gemäß einem weiteren Ausführungsbeispiel;
Fig. 3 einen schematischen Querschnitt einer Hochspannungsgarnitur gemäß noch einem weiteren Ausführungsbeispiel;
Fig. 4 einen schematischen Querschnitt einer Hochspannungsgarnitur gemäß einem weiteren Ausführungsbeispiel; und
Fig. 5 einen schematischen Querschnitt einer Hochspannungsgarnitur gemäß noch einem weiteren Ausführungsbeispiel.
Fig. 6 einen schematischen Querschnitt einer Hochspannungsgarnitur gemäß einem weiteren Ausführungsbeispiel.

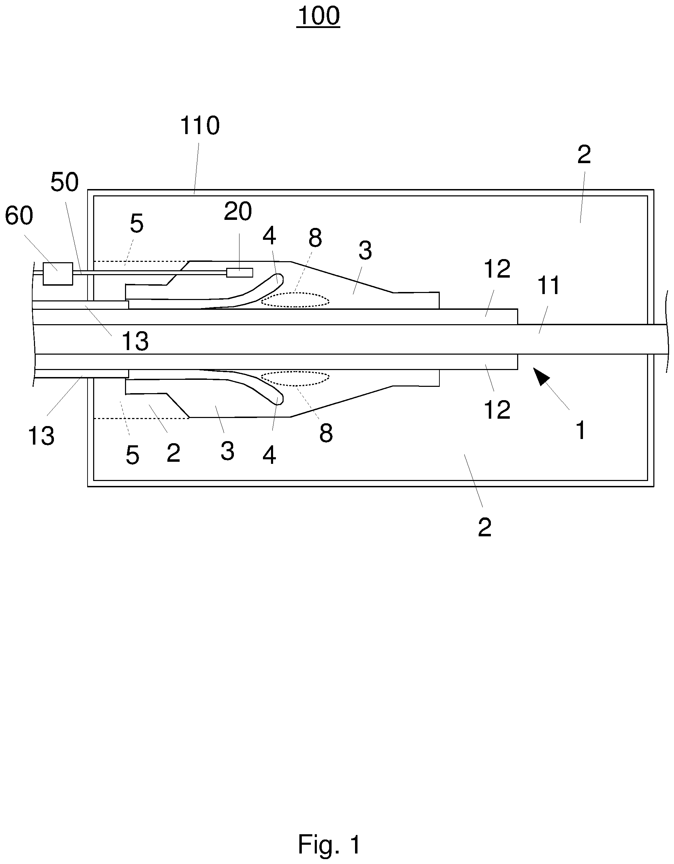

Fig. 1 zeigt eine Hochspannungsgarnitur 100 zur Aufnahme eines Hochspannungskabels 1 gemäß einem Ausführungsbeispiel in einer schematischen zentralen Querschnittsansicht entlang der Zylinderachse des Hochspannungskabels 1. Das rotationssymmetrische Hochspannungskabel 1 enthält im Innern einen Leiter 11 zum Leiten von Starkstrom, bspw. einen Aluminium- oder Kupferleiter, der von einer Kabelisolierung 12, typischerweise einer VPE-Isolierung (vernetztes Polyethylen), und einer äußeren Kabelschirmung 13, z.B. einer äußeren Leitschicht oder einem halbleitenden äußeren Kabelschirm, umgeben ist. Weiterhin kann das Hochspannungskabel 1 zusätzlich Polsterschichten und einen Kupferschirm und einen äußeren Mantel zum Schutz gegenüber Umwelteinflüssen aufweisen. Dabei kann es sich um einen Polyethylen-Mantel oder einen Mantel aus einem anderen halogenfreien Material handeln. Diese Komponenten sind in Fig. 1 und den folgenden Figuren aus Gründen der Übersichtlichkeit nicht dargestellt. Außerdem kann das Hochspannungskabel 1 eine innere Leitschicht zwischen dem Leiter 11 und der VPE-Isolierung aufweisen. Diese innere Leitschicht ist ebenfalls nicht dargestellt.

Die in Fig. 1 dargestellte Hochspannungsgarnitur 100 stellt einen Kabelendverschluss 100 dar, wie er z.B. bei Freileitungen verwendet wird. Der Kabelendverschluss 100 hat ein Gehäuse 110, z.B. ein Keramikgehäuse, das die inneren Teile der Hochspannungsgarnitur 1 gegenüber der Umgebung abschließt. Im Innern des Gehäuses ist ein Isoliergebiet 2 angeordnet. Das Isoliergebiet 2 kann z.B. durch einen mit Öl oder Gas gefüllten Isolierraum gebildet werden. Das Isoliergebiet 2 bildet ein im Wesentlichen zylindersymmetrisches Gebiet.

An dem in den Kabelendverschluss eingeführten Hochspannungskabel 1 sind die äußeren Schichten (Kabelmantel, Polsterschichten und metallischer Schirm) entfernt, die typischerweise halbleitende äußere Kabelschirmung 13 bis in den Bereich des Feldsteuerteils weitergeführt und danach durch den Endverschluss hindurch bis zur Kopfarmatur nur noch die Kabelisolierung 12 mit dem Leiter 11 axial weitergeführt. Nur der Leiter 11 wird vollständig durch den Kabelendverschluss 100 geführt, um im rechten Bereich von Figur 1 nach Verlassen des Kabelendverschlusses 100 an die Freileitung angeschlossen zu werden. Im Innern des Kabelendverschlusses 100 ist der Leiter 11 nur im Bereich der entfernten Kabelisolierung vom Isoliergebiet 2 direkt umgeben. Zur Aufnahme des Hochspannungskabels 1 ist in das Isoliergebiet 2 ein rotationssymmetrisches elektrisch isolierendes Feldsteuerteil 3 eingesetzt, das denjenigen Raum innerhalb des Isoliergebietes 2 einnimmt, in dem die elektrische Feldstärke zu groß für die Isoliermaterialien im Isoliergebiet 2 wäre. Das Feldsteuerteil 3 verfügt über einen inneren Hohlzylinder, in den das Hochspannungskabel 1 eingeschoben werden kann. Beispielsweise kann das Feldsteuerteil 3 als Feldsteuerkonus ausgeführt sein. Typischerweise ist das Feldsteuerteil 3 ein elastomeres Feldsteuerteil, das aus einem Elastomerkörper besteht, z.B. aus einem Silikonelastomerkörper. Der innere Hohlzylinder ist typischerweise so dimensioniert, dass zwischen der Kabelisolierung 12 des eingeschobenen Kabels 1 und dem Feldsteuerteil 3 eine Presspassung vorliegt und das Feldsteuerteil 3 somit einen Stresskonus bildet. Das Isoliergebiet 2 und das Feldsteuerteil 3 bilden zusammen die Isolierung 2, 3 des Kabelendverschlusses 100.

Das Feldsteuerteil 3 und/oder das Hochspannungskabel 1 können zusätzlich, beispielsweise über Federn, am Gehäuse 110 oder in einem sich auf Erdpotential befindenden kabelnahen Bereich 5 des Isoliergebiets 2 fixiert werden, z.B. wenn das Isoliergebiets 2 durch einen Feststoffisolierkörper gebildet ist. Eine derartige Fixierung von Feldsteuerteil 3 und/oder Hochspannungskabel 1 wird typischerweise bei einem Aufbau des Kabelendverschlusses 100 in Komponentenbauweise verwendet. Alternativ dazu kann der Aufbau des Kabelendverschlusses 100 auch entsprechend der Wickeltechnik oder Aufschiebetechnik ausgeführt sein. Die Isolierung umfasst unabhängig von der verwendeten Bauweise ein Feldsteuerteil 3 zur Aufnahme des Kabels 1 mit teilweise entfernter Kabelisolierung 12 und zur geeigneten Führung der Feldlinien im Hochspannungsbetrieb.

Für den Abbau des elektrischen Feldes wird typischerweise ein elastomeres Feldsteuerteil 3 verwendet, in das ein geeignet geformter leitfähiger Deflektor 4 integriert ist. Der leitfähige Deflektor 4 ist in elektrischem Kontakt mit der Kabelschirmung 13. Typischerweise besteht der leitfähige Deflektor 4 ebenfalls aus einem Silikoneleastomer, der jedoch durch Dotierung über eine geeignete elektrische Leitfähigkeit verfügt. Aufgrund von Materialinhomogenitäten oder Fehlern gibt es typischerweise Bereiche erhöhter Feldstärke. Diese werden in Fig. 1 von den gestrichelt umrandeten Bereichen 8 repräsentiert. Die Wahrscheinlichkeit für das Auftreten bzw. Einsetzen von Teilentladungen ist in den Bereichen 8 mit erhöhter Feldstärke erhöht.

Gemäß einem Ausführungsbeispiel ist im Innern der Hochspannungsgarnitur 100 ein faseroptischer Sensor 20 angeordnet. Der faseroptische Sensor 20 ist vollständig in das Feldsteuerteil 3 eingebettet, der die Kabelisolierung 12 des Hochspannungskabels 1 und damit dessen Leiter 11 im zuvor beschriebenen Bereich umgibt. Das Feldsteuerteil 3 stellt damit zumindest einen Teil einer Isolierung der Hochspannungsgarnitur 100 dar. Bei dem faseroptischen Sensor 20 handelt es sich um einen Sensor, der eine mechanische Deformation in einem angrenzenden Medium, d.h. im Feldsteuerteil 3 detektieren kann. Über eine oder mehrere optische Versorgungsfasern 50 können dem typischerweise passiven faseroptischen Sensor 20 optische Mess- oder Prüfsignale zu- und wieder abgeführt werden. Damit wird eine galvanische Verbindung zwischen dem faseroptischen Sensor 20 und einer Auswerteeinheit vermieden.

Faseroptische Sensoren können besonders empfindlich mechanische Deformationen nachweisen. Außerdem ist der faseroptische Sensor 20 typischerweise so ausgeführt, dass er nur aus dielektrischen Materialien besteht, z.B. aus Glas oder Polymerwerkstoff, und daher die elektrische Feldverteilung im Kabelendverschluss 100 gar nicht oder nur unwesentlich verändert. Zum anderen wird der faseroptische Sensor 20 praktisch nicht durch äußere elektromagnetische Felder beeinflusst. Daher kann der faseroptische Sensor 20 auch in der Nähe von Bereichen 8 mit besonders hoher Feldstärke, und daher in der Nähe von Risikobereichen, für das Detektieren von Teilentladungen positioniert werden. Damit kann eine empfindliche Überwachung von Teilentladungen während des Betriebs, d.h. unter Hochspannungsbedingungen, sichergestellt werden. Dies erhöht die Sicherheit des Betriebs von Hochspannungsanlagen. Außerdem können die Messergebnisse oder die Messsignale über eine oder mehrere optische Versorgungsfasern 50 in eine zentrale Überwachungsstelle weitergeleitet werden, so dass aufwendige Messkampagnen vor Ort entfallen können. Auf Grund der geringen Faserdämpfung sind sogar faseroptische Messungen von einer zentralen Überwachungsstelle aus über große Entfernungen möglich.

Falls die effektive Dielektrizitätskonstante des faseroptischen Sensors 20 von der Dielektrizitätskonstante des Feldsteuerteils 3 abweicht, kann es zu einer Veränderung der elektrischen Feldverteilung im Feldsteuerteil 3 kommen. Für diesen Fall kann die Form und/oder Leitfähigkeit des leitfähigen Deflektors 4 so modifiziert werden, dass die durch den faseroptischen Sensor 20 und/oder die optischen Versorgungsfasern 50 entstandene Veränderung des elektrischen Feldes kompensiert wird.

Im Vergleich zu außerhalb der Hochspannungsgarnitur angeordneten elektromagnetischen oder piezoelektrischen Sensoren oder Messaufbauten, deren Messempfindlichkeit während des Hochspannungsbetriebs durch elektromagnetische Grundstörpegel im Bereich von etwa 20 pC bis etwa 50 pC begrenzt ist, ermöglicht der mechanisch mit der Isolierung gekoppelte faseroptischen Sensor 20 eine empfindlichere Detektion von Deformationen und/oder Vibrationen der Isolierung und damit eine frühere Detektion von Teilentladungen. Neben der in Fig. 1 illustrierten vollständigen Einbettung des faseroptischen Sensors 20, ist es auch möglich, den faseroptischen Sensor 20 nur teilweise in das typischerweise elastomere Feldsteuerteil 3 einzubetten.

Die Anordnung des faseroptischen Sensors 20 innerhalb der Hochspannungsgarnitur 100 schützt diesen außerdem vor äußeren Einflüssen, so dass zuverlässige und wartungsarme Sensoren für Teilentladungen zu Verfügung gestellt werden können.

Bei dem faseroptischen Sensor 20 handelt es sich typischerweise um einen passiven Sensor, der mit einem optischen Prüfsignal, z.B. einem Lasersignal, über eine der optischen Versorgungsfasern 50 versorgt wird. Diese Prüfsignale können von einer zentralen Versorgungseinheit für eine oder mehrere Hochspannungsgarnituren 100 bereitgestellt werden.

Optional kann vorgesehen sein, die optischen Prüfsignale, z. B. geeignete Laserpulse, in einer sich in der Nähe des Kabelendverschlusses 100 befindlichen Mess- und Auswerteeinrichtung 60 zu erzeugen, und dort auch die Messwerterfassung, -aufbereitung und/oder -bewertung durchzuführen. In diesen Ausführungsbeispielen werden typischerweise nur noch die Messergebnisse selbst an die Überwachungsstelle weitergeleitet. Dadurch kann die Menge der Daten und deren Logistik wesentlich vereinfacht werden. Typischerweise befindet sich die Mess- und Auswerteeinrichtung 60 dabei außerhalb des Hochspannungsgebietes, d.h. außerhalb des Kabelendverschlusses 100 oder im sich auf Erdpotential befindenden kabelnahen Bereich 5, um die Elektronik der Mess- und Auswerteeinrichtung 60 nicht zu stören.

Bei dem faseroptischen Sensor 20 kann es sich um einen Dehnungssensor und/oder einen Biegesensor handeln. Damit lassen sich Formveränderungen des Feldsteuerteils 3 nachweisen, die einen deutlichen Hinweis auf einen bevorstehenden Durchbruch geben. Somit kann ein rechtzeitiger Wechsel des Kabelendverschlusses 100 vorgenommen werden.

Bei dem faseroptischen Sensor 20 kann es sich insbesondere um einen Schallsensor handeln, der die von Teilentladungen verursachten Schallemissionen detektiert. Dazu ist der faseroptische Sensor 20 typischerweise so eingerichtet, dass er mechanische Schwingungen mit Frequenzen im Bereich von etwa 10 kHz bis etwa 5 MHz, und insbesondere Frequenzen im Bereich von etwa 50 kHz bis etwa 500 MHz detektieren kann. Es kann aber auch vorgesehen sein, dass der faseroptische Sensor 20 nur in ausgewählten Teilbereichen oder auch in relativ engen ausgewählten Frequenzbändern sensitiv ist, wobei dessen Teilbereiche bzw. Frequenzbänder bei gegebenen Isoliermaterialien und Spannungen auf die dann zu erwartenden Schallfrequenzen von Teilentladungen abgestimmt sind.

Auf Grund der mechanischen Kopplung zwischen dem Feldsteuerteil 3, dem Isoliergebiet 2 und der Kabelisolierung 12 können vom faseroptischen Sensor 20 typischerweise auch Schallereignisse detektiert werden, die durch Teilentladungen im Isoliergebiet 2 oder der Kabelisolierung 12 verursacht werden.

Zum Nachweis von Schallereignissen im Kabelendverschlusses 100 und/oder von voranschreitenden Deformationen im Feldsteuerteil 3 und/oder im Isoliergebiet 2 und/oder in der Kabelisolierung 12 können verschiedene Messprinzipien benutzt werden. So kann der faseroptische Sensor 20 zur Messung einer Änderung der Phasenlage, der Polarisation oder der Lichtintensität eingerichtet sein.

Gemäß einer Ausführungsform ist der faseroptische Sensor 20 ein Faserspitzensensor. Der Faserspitzensensor kann aus nur einer Faserspitze oder aus mehren Faserspitzen bestehen. Wenn eine Faserspitze in ein optisch transparentes oder transluzentes Medium, wie ein Silikonelastomer als Kabelisolierung, eingebettet wird oder an diese zumindest angrenzt, so kann anhand des an der Grenzfläche von Faserkern zum Medium rückgestreuten Lichts auf die optische Brechzahl und damit auf die Dichte des angrenzenden Elastomers geschlossen werden. Somit können Dichteveränderungen und/oder Oszillationen des Elastomers optisch über das rückgestreute Licht nachgewiesen werden.

Typischerweise ist der faseroptische Sensor 20 ein phasensensitiver Sensor, z.B. ein interferometrischer Sensor. Der faseroptische Sensor 20 kann z.B. ein Fabry-Perot-Interferometer sein. Damit lassen sich besonders empfindliche Messungen realisieren.

Bei dem faseroptischen Sensor 20 kann es sich auch um einen Faser-Bragg-Gittersensor handeln mit dem sich insbesondere Lambwellen, d.h. gemischte Druck- und Scherwellen, detektieren lassen. Der Faser-Bragg-Gittersensor ist dabei typischerweise so ausgeführt, dass er irreversible Deformationen des Feldsteuerteils 3 und/oder Schallereignisse detektieren kann. Irreversible Deformationen des Feldsteuerteils 3 können von elektrischen Teilentladungen verursacht werden, aber auch elektrischen Teilentladungen vorausgehen. So kann es bspw. bei sehr großen Endverschlüssen mit Ausdehnungen von bis zu einigen Metern zu mechanischen Setzungserscheinungen der entsprechend schweren Komponenten kommen. Damit können Spannungen bzw. Verformungen des Feldsteuerteils 3 verbunden sein, die ihrerseits elektrische Teilentladungen begünstigen bzw. initiieren können. Mit einem Faser-Bragg-Gittersensor können somit auch elektrische Teilentladungen verursachende Strukturschädigungen detektiert werden.

Bei dem faseroptischen Sensor 20 kann es sich aber auch um einen quasiverteilten faseroptischen Sensor handeln. Dieser besteht aus einer Faser mit mehreren Messpunkten, die sich in regelmäßigen Abständen zueinander befinden. Über zeitbasierte Rückstreumessungen lassen sich irreversibel Deformationen und somit auch elektrische Teilentladungen verursachende Veränderungen im Feldsteuerteil 3 abschnittsweise entlang der Faser im Feldsteuerteil 3 detektieren.

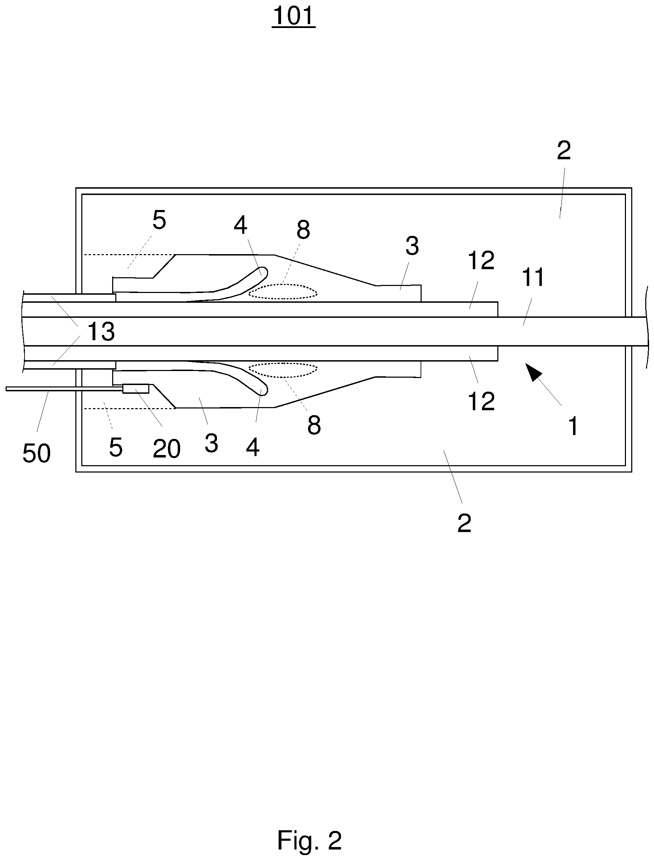

Fig. 2 zeigt eine Hochspannungsgarnitur 101 zur Aufnahme eines Hochspannungskabels 1 gemäß einem Ausführungsbeispiel in einer schematischen zentralen Querschnittsansicht entlang der Zylinderachse des Hochspannungskabels 1. Die Hochspannungsgarnitur 101 ist ähnlich zur Hochspannungsgarnitur 100 und stellt ebenfalls einen Kabelendverschluss dar. Im Kabelendverschluss 101 ist der faseroptische Sensor 20 jedoch auf einer Oberfläche des Feldsteuerteils 3 im sich auf Erdpotential befindenden kabelnahen Bereich 5 angeordnet. Dort kann der faseroptische Sensor 20 ebenfalls eine mechanische Deformation des Feldsteuerteils 3 detektieren.

Auf Grund der mechanischen Kopplung zwischen dem Feldsteuerteil 3, dem Isolierkörpergebiet 2 und der Kabelisolierung 12 können vom faseroptischen Sensor 20 typischerweise auch Schallereignisse detektiert werden, die durch Teilentladungen im Isolierkörpergebiet 2 oder der Kabelisolierung 12 verursacht werden.

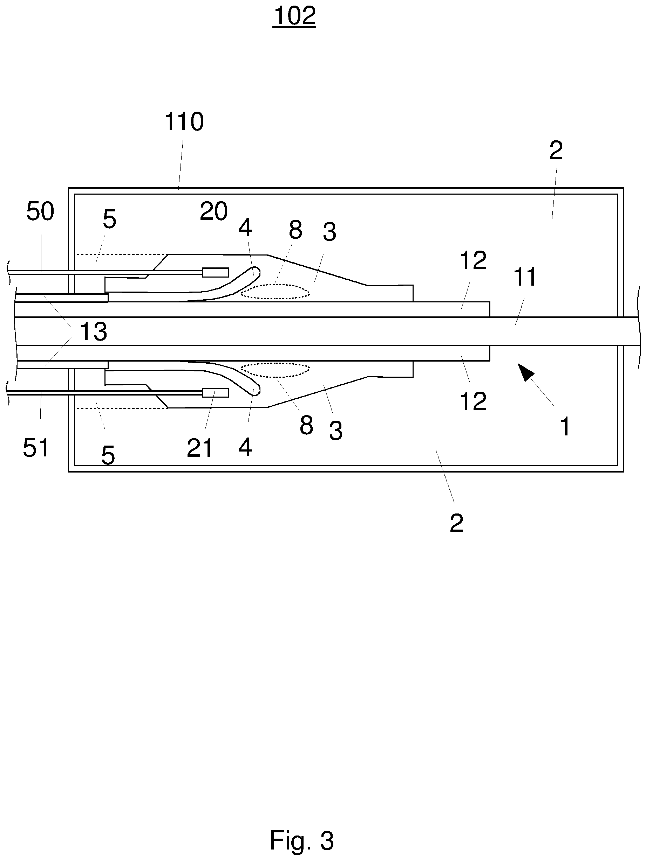

Fig. 3 zeigt eine Hochspannungsgarnitur 102 zur Aufnahme eines Hochspannungskabels 1 gemäß einem Ausführungsbeispiel in einer schematischen zentralen Querschnittsansicht entlang der Zylinderachse des Hochspannungskabels 1. Die Hochspannungsgarnitur 102 ist ähnlich zur Hochspannungsgarnitur 100 und stellt ebenfalls einen Kabelendverschluss dar. Der Kabelendverschluss 102 hat jedoch zwei faseroptische Sensoren 20 und 21 zur Detektion von mechanischen Deformationen und/oder Schwingungen, die beide in das Feldsteuerteil 3 eingebettet und über jeweilige optische Versorgungsfasern 50 und 51 angeschlossen sind. Die beiden faseroptische Sensoren 20 und 21 können z.B. bei unterschiedlichen Frequenzen oder auf unterschiedlichen Frequenzbändern von Teilentladungen sensitiv für Schallereignisse sein. Damit können Teilentladungen fehlertolerant nachgewiesen und gegenüber extern verursachten Schwingungen abgegrenzt werden, ohne ein ganzes Schallspektrum aufnehmen zu müssen. Es versteht sich von selbst, dass auch mehr als zwei faseroptische Sensoren in der Hochspannungsgarnitur 102 verwendet werden können. Bei der Verwendung von mindestens drei oder mehr als drei faseroptischen Sensoren können diese auch zur genauen Lokalisierung der die Schallemission verursachenden Teilentladung verwendet werden. Dies eröffnet die Möglichkeit, das Wachstum eines Entladungsbäumchens auch quantitativ zu erfassen, was zu einer weiter verbesserten Prognose des Alterungszustands des Isoliermaterials im Feldsteuerteil 3 verwendet werden kann. Außerdem können einer oder mehrere erste faseroptischen Sensoren schallsensitiv sein und einer oder mehrere zweite faseroptischen Sensoren zur Messung von irreversiblen Deformationen eingerichtet sein. Mit dem einen oder den mehreren ersten faseroptischen Sensoren können elektrische Teilentladungen, und mit dem einen oder den mehreren zweiten faseroptischen Sensoren Strukturschädigungen detektiert werden, die elektrischen Teilentladungen vorausgehen können.

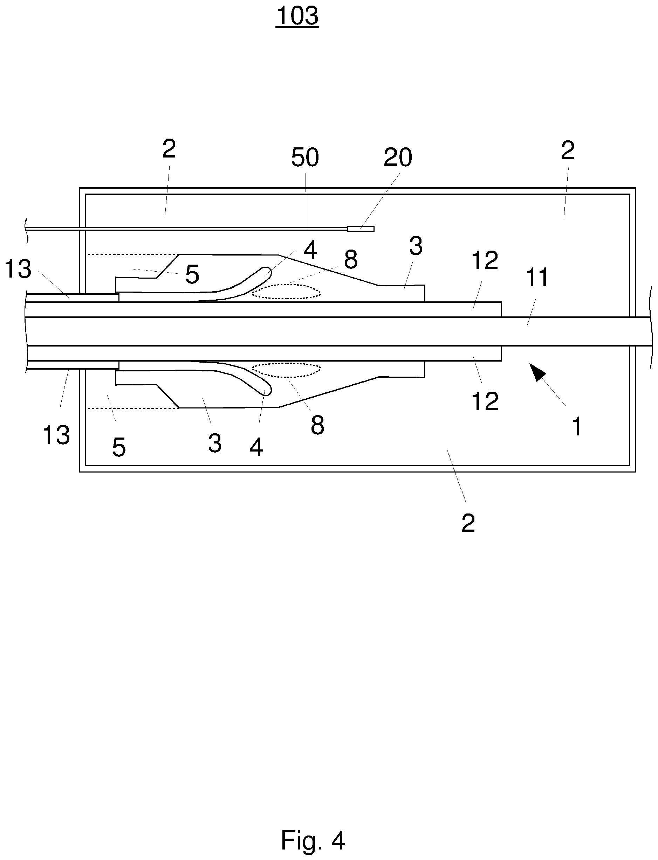

Fig. 4 zeigt eine Hochspannungsgarnitur 103 zur Aufnahme eines Hochspannungskabels 1 gemäß einem Ausführungsbeispiel in einer schematischen zentralen Querschnittsansicht entlang der Zylinderachse des Hochspannungskabels 1. Die Hochspannungsgarnitur 103 ist ähnlich zur Hochspannungsgarnitur 100 und stellt ebenfalls einen Kabelendverschluss dar. Der faseroptische Sensor 20 des Kabelendverschlusses 103 ist jedoch nicht in den Feldsteuerteil 3, sondern im angrenzenden Isoliergebiet 2 angeordnet. Bei dem Isoliergebiet 2 kann es sich um ein gas- oder ölgefülltes Isoliergebiet 2 handeln. Das Isoliergebiet 2 kann aber auch ein Feststoffisolierkörper 2 sein, in den der faseroptische Sensor 20 eingebettet ist. Auf Grund der mechanischen Kopplung zwischen Feldsteuerteil 3 und Isoliergebiet 2 können vom faseroptischen Sensor 20 im Isoliergebiet 2 auch Schallereignisse, die von Teilentladungen im Feldsteuerteil 3 und/oder in der Kabelisolierung 12 und/oder im Isoliergebiet 2 verursacht werden, nachgewiesen werden.

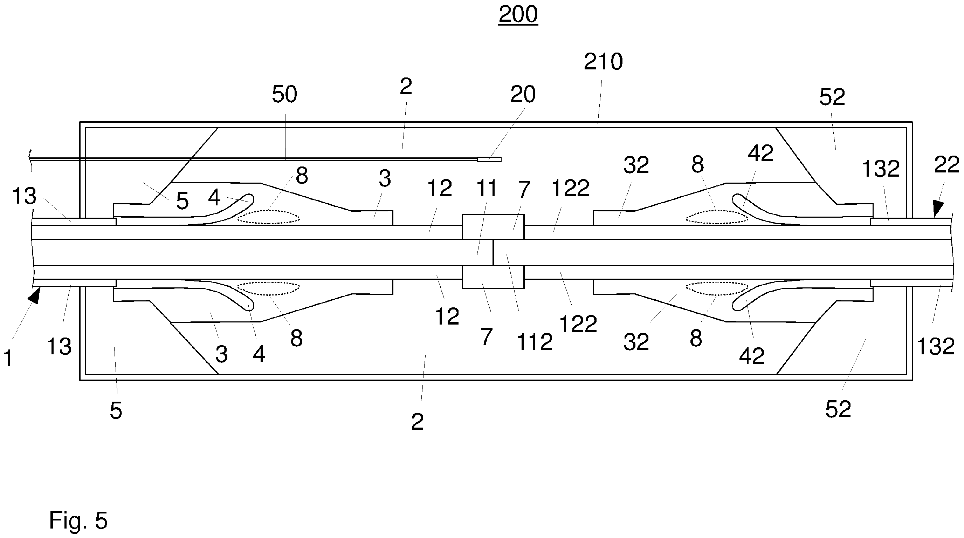

Fig. 5 zeigt eine Hochspannungsgarnitur 200 zur Aufnahme zweier Hochspannungskabel 1 und 22 gemäß einem Ausführungsbeispiel in einer schematischen zentralen Querschnittsansicht entlang der Zylinderachsen der koaxial orientierten Hochspannungskabel 1 und 22. Die rotationssymmetrischen Hochspannungskabel 1, 22 umfassen jeweils einen Leiter 11 bzw. 112 zum Leiten von Starkstrom und eine den jeweilige Leiter 11, 112 umgebende Kabelisolierung 12, 122. Die Hochspannungsgarnitur 200 stellt eine Hochspannungskabelmuffe zum Verbinden zweier Hochspannungskabel dar. Die Kabelmuffe 200 hat ein Gehäuse 210, z.B. ein Metallgehäuse, in dem die Hochspannungskabel 1 und 22 zentrisch angeordnet sind. Ein komplex aufgebauter elastomerer Muffenkonus mit Feldsteuerteilen 3, 32, die in ein Isoliergebiet 2 eingebettet sind und die das jeweils an den zusammengefügten Kabelenden auftretende Hochspannungsfeld definiert abbauen, übernimmt die Feldsteuerung der zu verbindenden Hochspannungskabel 1 und 22. Das Isoliergebiet 2 der Kabelmuffe 200 wird typischerweise von einem Gießharzisolator oder einem Silikonkörper gebildet. Weiterhin ist die Isolierung und Feldsteuerung im Bereich der verbundenen metallischen Leiter 11, 112 wieder herzustellen. Dies geschieht z.B. über z.B. eine Crimpverbindung und mit einem schwachleitfähigen Polymerring 7, die ebenfalls in das Isoliergebiet 2 eingebettet sind. Die typischerweise rotationssymmetrische Isolierung 2, 3, 32 der Kabelmuffe 200 wird von den Feldsteuerteilen 3, 23 und dem Isoliergebiet 2 gebildet. Außerdem kann das Isoliergebiet 2 durch eine nichtdargestellte äußere, leitfähige Muffenbeschichtung abgeschlossen sein, die auf der äußeren Oberfläche des Isoliergebiets 2 angeordnet ist, wobei ein kleiner Spalt zum Gehäuse 210 verbleiben kann, und die sich zusammen mit den Kabelschirmungen 13, 132 auf Erdpotential befindet. Typischerweise handelt es sich bei den Feldsteuerteilen 3, 32 um elastomere Feldsteuerteile 3, 32, in die ein jeweiliger leitfähiger Deflektor 4, 42 integriert ist. Die Kabelmuffe 200 kann in Komponentenbauweise, in Extrusionstechnik oder entsprechend der Wickeltechnik oder der Aufschiebetechnik ausgeführt sein. So kann die Isolierung der Kabelmuffe in Komponentenweise aus einem zusammenhängenden elastomeren Feldsteuerteil mit integrierten Deflektoren 4, 42 bestehen, das den Raum der in Fig. 5 gezeigten Feldsteuerteile 3, 32 und des Isoliergebiets 2 einnimmt, wobei ein kleiner Spalt zum Gehäuse 210 verbleiben kann, und das von einer äußeren, leitfähigen Muffenbeschichtung auf Erdpotential abgeschlossen ist. Die Isolierung umfasst aber unabhängig von der Herstellungstechnik zumindest ein Feldsteuerteil 3, 32 zur Aufnahme der Kabel 1, 22 mit an den jeweiligen Kabelenden entfernter Kabelisolierung 12, 122 und zur geeigneten Führung der Feldlinien im Hochspannungsbetrieb.

Gemäß einer Ausführungsform ist ein faseroptischer Sensor 20, wie er mit Bezug zu den Figuren 1 bis 4 beschrieben wurde, in dem Isoliergebiet 2 angeordnet bzw. in das Isoliergebiet 2 eingebettet. Dies bedeutet, dass es sich auch bei dem faseroptischen Sensor 20 um einen Sensor handelt, der eine Deformation, insbesondere eine oszillierende Deformation, z.B. eine Schwingung des ihn umgebenden Mediums detektieren kann. Damit können auftretende Teilentladungen in der Isolierung der Kabelmuffe 200 sicher nachgewiesen und einfach über längere Zeiträume während des Hochspannungsbetriebs beobachtet werden. Es versteht sich, dass der faseroptische Sensor 20 auch in einen der beiden oder in beide Feldsteuerteile 3 und 32 eingebettet, oder an einer Oberfläche eines der beiden oder beider Feldsteuerteile 3 und 32 im jeweiligen sich auf Erdpotential befindenden kabelnahen Bereich 5, 52 sowie auf der leitfähigen Muffenbeschichtung angeordnet sein kann.

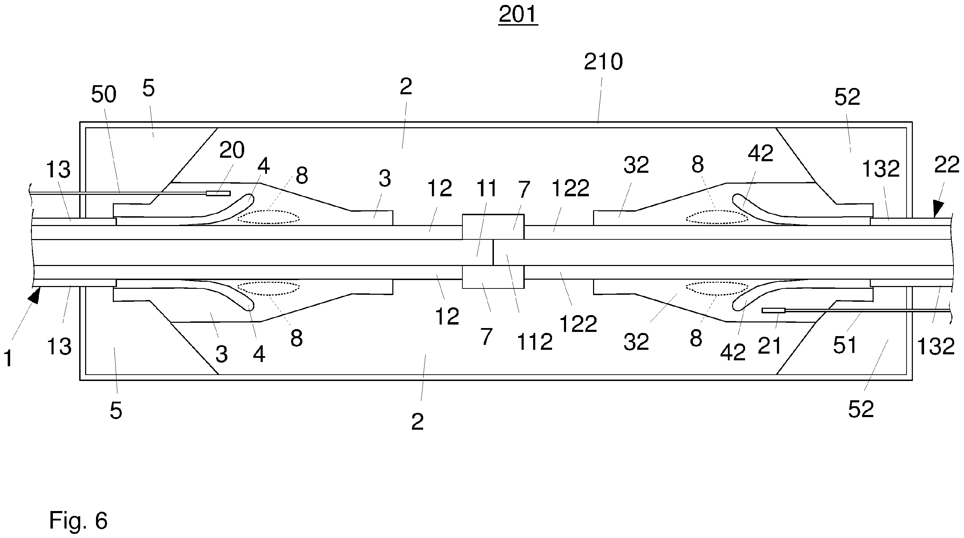

Fig. 6 zeigt eine Hochspannungsgarnitur 201 zur Aufnahme zweier Hochspannungskabel 1 und 22 gemäß einem Ausführungsbeispiel in einer schematischen zentralen Querschnittsansicht entlang der Zylinderachsen der koaxial orientierten Hochspannungskabel 1 und 22. Die Hochspannungsgarnitur 201 ist ähnlich zur Hochspannungsgarnitur 200 und stellt ebenfalls eine Kabelmuffe dar. In der Kabelmuffe 201 ist jedoch in jedes der beiden Feldsteuerteile 3 und 32 ein faseroptischer Sensor 20, 21 eingebettet, der über optische Versorgungsfasern 50 bzw. 51 angeschlossen ist. Durch die Verwendung zweier faseroptischer Sensoren 20, 21 können in der Kabelmuffe 201 auftretende mechanische Deformationen und/oder Schallereignisse sicher detektiert und/oder besser lokalisiert, d.h. z.B. einem der beiden Feldsteuerteile 3 und 32 zugeordnet werden. Außerdem erhöht sich typischerweise die Messempfindlichkeit, da die faseroptischen Sensoren 20, 21 näher zu den am stärksten teilentladungsgefährdeten Bereichen 8 mit erhöhter Feldstärke angeordnet werden können.

Die beiden faseroptischen Sensoren 20, 21 können auch in das Isoliergebiet 2, an einer Oberfläche des Isoliergebiets 2 und/oder an jeweils einer Oberfläche der beiden Feldsteuerteile 3 und 32 angeordnet sein. Außerdem können auch mehr als zwei faseroptische Sensoren innerhalb der Kabelmuffe 201 angeordnet sein, was zu einer sicheren Detektion und/oder genaueren Lokalisierung der Teilentladung genutzt werden kann. Jeder der mehreren faseroptischen Sensoren ist dabei typischerweise in das Isoliergebiet 2 oder in einen der beiden oder in beide Feldsteuerteile 3 und 32 eingebettet, oder an einer Oberfläche des Isoliergebiets 2 und/oder eines der beiden oder beider Feldsteuerteile 3 und 32 angeordnet.

Gemäß einer Ausführungsform umfasst ein Verfahren zur Detektion von Teilentladungen in einer Isolierung einer Hochspannungsgarnitur, z.B. einer Kabelmuffe oder eines Kabelendverschlusses, die Messung einer mechanischen Größe der Isolierung mittels eines faseroptischen Sensors. Typischerweise umfasst die Isolierung ein Feldsteuerteil, z.B. einen elastomeren Feldsteuerteil. Der faseroptische Sensor kann auf einer Oberfläche des Feldsteuerteils angeordnet und/oder teilweise oder ganz eingebettet sein. Damit ist der faseroptische Sensor typischerweise innerhalb der Hochspannungsgarnitur angeordnet. Durch Verwendung derartig integrierter faseroptischer Sensoren können die von Teilentladungen verursachten Deformationen und/oder Vibrationen in der Isolierung von Hochspannungsgarnituren zuverlässig und sehr empfindlich detektiert werden. Gegenüber elektromagnetischen oder piezoelektrischen Messungen mit außerhalb der Hochspannungsgarnitur angeordneten Sensoren oder Messaufbauten, ermöglichen die teilweise oder ganz in der Isolierung eingebetteten bzw. auf der Oberfläche des elastomeren Feldsteuerteils angeordneten faseroptischen Sensoren damit typischerweise eine frühe Detektion von Teilentladungen. Die zeitliche Entwicklung der Teilentladung lässt sich damit ab einem sehr frühen Zeitpunkt verfolgen. Dies führt zu einer weiter verbesserten Prognose des Alterungszustands der Kabelisolierung und trägt damit zur Erhöhung der Betriebssicherheit bei.

Die Messung einer mechanischen Größe umfasst dabei typischerweise die Messung eines Drucks, einer Spannung, einer Deformation und/oder einer Schwingung in der Isolierung, z.B. eines Frequenzspektrums und/oder einer Körperschalldauer. Auf Grund des charakteristischen Frequenzspektrums von Schallemissionen, die durch Teilentladungen verursacht werden, lassen faseroptische Messungen der Schwingung in der Isolierung einen besonders zuverlässigen Rückschluss auf Teilentladungen bzw. die damit verbundene Entwicklung von Entladungsbäumchen und Materialzerstörungen zu.

Die Messung der mechanischen Größe erfolgt typischerweise im stromdurchflossenen Zustand der Hochspannungsgarnitur während des Betriebs. Dies ermöglicht zudem eine kontinuierliche oder ereignisabhängige Messung der mechanischen Größe, d.h. ein Monitoring von Teilentladungen im laufenden Betrieb. Dadurch kann die Sicherheit eines Hochspannungsnetzes und/oder einer Hochspannungseinrichtung, deren Hochspannungsgarnituren mit integrierten faseroptischen Sensoren überwacht werden, wesentlich verbessert werden.

Gemäß einer Ausführungsform werden die an den einzelnen Hochspannungsgarnituren einer Hochspannungsanlage oder eines Hochspannungsnetzes gemessenen mechanischen Größen über eine Onlineverbindung, z.B. über ein Glasfasernetzwerk, an eine zentrale Auswerteeinheit oder Kontrolleinheit übermittelt, die das Monitoring übernimmt. Diese wird typischerweise bei Detektion von Teilentladungsaktivitäten unverzüglich eine entsprechende Warnmeldung ausgeben. Damit kann ein Wechsel der gefährdeten Hochspannungsgarnitur rechtzeitig vor einem drohenden Durchbruch erfolgen.

Dabei können sich die faseroptischen Sensoren eine gemeinsame Datenleitung, z.B. eine optische Datenleitung, teilen, um mit der zentralen Auswerteeinheit zu kommunizieren. Ein derartiges faseroptisches Netzwerk kann außerdem eine zentrale Lichtquelle, z.B. einen Laser, Glasfasern, die das Licht zu den einzelnen passiven faseroptischen Sensoren führen, sowie einen weiteren Satz von Fasern, der das gegebenenfalls modulierte Licht zu einem gemeinsamen Fotodetektor in der zentralen Auswerteeinheit leitet, umfassen. Die Kommunikation zwischen den faseroptischen Sensoren und der zentralen Auswerteeinheit kann auch über einen optischen Multiplexer erfolgen.

Gemäß einer Ausführungsform wird ein faseroptisches Messsystem bereitgestellt. Das faseroptisches Messsystem umfasst eine zentrale Auswerteeinheit, eine Lichtquelle, typischerweise einen Laser, eine Detektionseinheit mit mindestens einem Fotosensor, einen oder mehrere passive faseroptische Sensoren, die eine mechanische Größe detektieren können und mechanisch mit einer jeweiligen Isolierung einer Hochspannungsgarnitur gekoppelt sind, sowie faseroptische Leitungen, die den einen oder die mehreren passiven faseroptischen Sensoren mit der Lichtquelle und der Detektionseinheit verbinden. Die Detektionseinheit kann dabei einen Teil der zentralen Auswerteeinheit darstellen. Die zentrale Auswerteeinheit ist eingerichtet, über die Auswertung der Messungen mechanischer Größen mittels des einen oder der mehreren faseroptischen Sensoren eine Teilentladung in einer Isolierung zu detektieren und/oder zu charakterisieren sowie entsprechende Warnmeldungen auszugeben. Damit kann ein einfaches Überwachungssystem für Teilentladungen in Hochspannungsgarnituren zur Verfügung gestellt werden, das ein kontinuierliches Monitoring während des Hochspannungsbetriebs der Hochspannungsgarnituren erlaubt und somit deren Sicherheit erhöht.

Die vorliegende Erfindung wurde anhand von Ausführungsbeispielen erläutert. Diese Ausführungsbeispiele sollten keinesfalls als einschränkend für die vorliegende Erfindung verstanden werden.

## Patentansprüche

1. Hochspannungsgarnitur (100, 101, 102, 103, 200, 201) zur Aufnahme eines Hochspannungskabels (1, 22) mit einem zum Leiten elektrischen Stroms von mehr als 1 A bei Spannungen oberhalb von 1 kV eingerichteten Leiter (11, 112) und einer den Leiter (11, 112) umgebenden Kabelisolierung (12, 122), umfassend:
- eine Isolierung (2, 3, 32) umfassend ein Feldsteuerteil (3, 32), das eingerichtet ist, die Kabelisolierung (12, 122) zumindest teilweise zu umgeben; und
- mindestens einen mit dem Feldsteuerteil (3, 32) mechanisch gekoppelten faseroptischen Sensor (20, 21), der eingerichtet ist, eine von einer elektrischen Teilentladung in der Isolierung (2, 3, 32) verursachte mechanische Deformation in der Isolierung (2, 3, 32) in Form von mechanischen Schwingungen mit Frequenzen im Bereich von etwa 10 kHz bis etwa 500 kHz zu detektieren.

2. Hochspannungsgarnitur (100, 101, 102, 103, 200, 201) nach Anspruch 1, wobei der mindestens eine faseroptische Sensor (20, 21) ein Schallsensor und/oder ein Dehnungssensor ist.

3. Hochspannungsgarnitur (100, 101, 102, 103, 200, 201) nach Anspruch 1 oder 2, wobei der mindestens eine faseroptischer Sensor (20, 21) ein phasensensitiver Sensor ist.

4. Hochspannungsgarnitur (100, 101, 102, 103, 200, 201) nach einem der vorangegangenen Ansprüche, wobei der mindestens eine faseroptische Sensor (20, 21) zumindest teilweise in das Feldsteuerteil (3, 32) eingebettet ist und/oder auf einer Oberfläche des Feldsteuerteils (3, 32) angeordnet ist, oder wobei die Isolierung (2, 3, 32) weiter ein Isoliergebiet (2) umfasst, das das Feldsteuerteil (3, 32) umgibt und in den der mindestens eine faseroptische Sensor (20, 21) zumindest teilweise eingebettet ist.

5. Hochspannungsgarnitur (100, 101, 102, 103, 200, 201) nach einem der vorangegangenen Ansprüche, wobei die Hochspannungsgarnitur (100, 101, 102, 103, 200, 201) eine Kabelmuffe (200, 201) oder ein Kabelendverschluss (100, 101, 102, 103) ist.

6. Hochspannungsgarnitur (100, 101, 102, 103, 200, 201) nach einem der vorangegangenen Ansprüche, wobei das Feldsteuerteil (3, 32) ein Elastomer umfasst.

7. Verfahren zur Detektion einer Teilentladung in der Isolierung (2, 3, 32) einer Hochspannungsgarnitur (100, 101, 102, 103, 200, 201) nach Anspruch 1, umfassend:
- Messung einer mechanischen Größe der Isolierung (2, 3, 32) mittels des mindestens einen faseroptischen Sensors (20, 21).

8. Verfahren nach Anspruch 7, wobei die Messung der mechanischen Größe im stromdurchflossenen Zustand der Hochspannungsgarnitur durchgeführt wird.

9. Verfahren nach Anspruch 7 oder 8, wobei die Messung der mechanischen Größe die Messung eines Drucks, einer Spannung, einer Deformation und/oder einer Schwingung in der Isolierung (2, 3, 32) umfasst.

10. Verfahren nach einem der Ansprüche 7 bis 9, wobei die Messung zeitlich kontinuierlich und/oder ereignisgesteuert ausgeführt wird.

## Claims

1. A high voltage fitting (100, 101, 102, 103, 200, 201) for receiving a high voltage cable (1, 22) having a conductor (11, 112) configured for conducting electrical current of more than 1 A at voltages above 1 kV, and having a cable insulation (12, 122) surrounding the conductor (11, 112), the high voltage fitting comprising:
- an insulation (2, 3, 32) comprising a field-control part (3, 32) configured to at least partially surround the cable insulation (12, 122); and
- at least one fiber-optic sensor (20, 21) mechanically coupled to the field-control part (3, 32) and configured to detect a mechanical deformation in the insulation (2, 3, 32) caused by a partial electric discharge in the insulation (2, 3, 32) in the form of mechanical vibrations having frequencies in the range from about 10 kHz to about 500 kHz.

2. The high voltage fitting (100, 101, 102, 103, 200, 201) according to claim 1, wherein the at least one fiber-optic sensor (20, 21) is an acoustic sensor and/or a strain sensor.

3. The high voltage fitting (100, 101, 102, 103, 200, 201) according to claim 1 or 2, wherein the at least one fiber-optic sensor (20, 21) is a phase-sensitive sensor.

4. The high voltage fitting (100, 101, 102, 103, 200, 201) according to any of the preceding claims, wherein the at least one fiber-optic sensor (20, 21) is at least partially embedded in the field-control part (3, 32) and/or is arranged on a surface of the field-control part (3, 32), or wherein the insulation (2, 3, 32) further comprises an insulation region (2) that surrounds the field-control part (3, 32) and in which the at least one fiber-optic sensor (20, 21) is at least partially embedded.

5. The high voltage fitting (100, 101, 102, 103, 200, 201) according to any of the preceding claims, wherein the high voltage fitting (100, 101, 102, 103, 200, 201) is a cable sleeve (200, 201) or a cable termination (100, 101, 102, 103).

6. The high voltage fitting (100, 101, 102, 103, 200, 201) according to any of the preceding claims, wherein the field-control part (3, 32) comprises an elastomer.

7. A method for detecting a partial discharge in the insulation (2, 3, 32) of a high voltage fitting (100, 101, 102, 103, 200, 201) according to claim 1, the method comprising:
- measuring a mechanical quantity of the insulation (2, 3, 32) by means of the at least one fiber-optic sensor (20, 21).

8. The method according to claim 7, wherein the measuring of the mechanical quantity is performed when there is current flowing through the high voltage fitting.

9. The method according to claim 7 or 8, wherein the measuring of the mechanical quantity comprises measuring a pressure, a voltage, a deformation, and/or a vibration in the insulation (2, 3, 32).

10. The method according to any of the claims 7 through 9, wherein the measuring is performed temporally continuously and/or in an event-controlled manner.

## Revendications

1. Garniture à haute tension (100, 101, 102, 103, 200, 201) pour le logement d'un câble à haute tension (1, 22) avec un conducteur (11, 112) conçu pour la conduction d'un courant électrique de plus de 1 A à des tensions supérieures à 1 kV et une isolation de câble (12, 122) entourant le conducteur (11, 112), comprenant :
- une isolation (2, 3, 32) comprenant une partie de contrôle de champ (3, 32) qui est conçue pour entourer au moins partiellement l'isolation de câble (12, 122) ; et
- au moins un capteur à fibre optique (20, 21) couplé mécaniquement avec la partie de contrôle de champ (3, 32), qui est configuré pour détecter une déformation mécanique dans l'isolation (2, 3, 32), provoquée par une décharge électrique partielle dans l'isolation (2, 3, 32), sous la forme de vibrations mécaniques avec des fréquences d'environ 10 kHz à environ 500 kHz.

2. Garniture à haute tension (100, 101, 102, 103, 200, 201) selon la revendication 1, l'au moins un capteur à fibre optique (20, 21) étant un capteur acoustique et/ou un capteur de contrainte.

3. Garniture à haute tension (100, 101, 102, 103, 200, 201) selon la revendication 1 ou 2, l'au moins un capteur à fibre optique (20, 21) étant un capteur sensible à la phase.

4. Garniture à haute tension (100, 101, 102, 103, 200, 201) selon l'une des revendications précédentes, l'au moins un capteur à fibre optique (20, 21) étant intégré au moins partiellement dans la partie de contrôle de champ (3, 32) et/ou étant disposé sur une surface de la partie de contrôle de champ (3, 32) ou l'isolation (2, 3, 32) comprenant en outre une zone d'isolation (2) qui entoure la partie de contrôle de champ (3, 32) et dans laquelle est intégré au moins partiellement l'au moins un capteur à fibre optique (20, 21).

5. Garniture à haute tension (100, 101, 102, 103, 200, 201) selon l'une des revendications précédentes, la garniture à haute tension (100, 101, 102, 103, 200, 201) étant un manchon de câble (200, 201) ou une tête de câble (100, 101, 102, 103).

6. Garniture à haute tension (100, 101, 102, 103, 200, 201) selon l'une des revendications précédentes, la partie de contrôle de champ (3, 32) comprenant un élastomère.

7. Procédé de détection d'une décharge partielle dans l'isolation (2, 3, 32) d'une garniture à haute tension (100, 101, 102, 103, 200, 201) selon la revendication 1, comprenant :
- la mesure d'une grandeur mécanique de l'isolation (2, 3, 32) au moyen de l'au moins un capteur à fibre optique (20, 21).

8. Procédé selon la revendication 7, la mesure de la grandeur mécanique étant effectuée lorsque la garniture à haute tension est traversée par un courant.

9. Procédé selon la revendication 7 ou 8, la mesure de la grandeur mécanique comprenant la mesure d'une pression, d'une tension, d'une déformation et/ou d'une vibration dans l'isolation (2, 3, 32).

10. Procédé selon l'une des revendications 7 à 9, la mesure étant effectuée de manière continue dans le temps et/ou lors d'un événement.
